# EUROPEAN PATENT APPLICATION

(11) **EP 1 610 604 A2**
(43) Date of publication of application: **28.12.2005**
(21) Application number: 05010664.0
(22) Date of filing: 17.05.2005
(51) Int. Cl.: H05K 7/14, G01R 31/04

(54) **Printed circuit assembly system and method**

(30) Priority: 14.06.2004 US 867450
(71) Applicant: Hewlett-Packard Development Company, L.P., Houston, TX 77070 (US)
(72) Inventor: Tam, Kin S., Elk Grove CA 95758 (US); Livingston, Christopher F., Roseville CA 95747 (US)
(74) Representative: Schoppe, Fritz

(57) **Abstract**

A printed circuit assembly (40) system (10) comprises an assembly module (12) adapted to automatically insert an electronic component (148) into a socket (48) of the printed circuit assembly (40) and automatically close the socket (48) to secure the electronic component (148) to the socket (48).

## Description

### BACKGROUND

Installing particular types of electronic components onto a printed circuit assembly generally requires insertion of the electronic components into a socket mounted to the printed circuit assembly and locking or otherwise closing the socket to secure the electronic component in the socket. For example, a central processing unit (CPU) is one example of an electronic component generally installed into a socket. However, installing electronic components into sockets on a motherboard or other type of printed circuit assembly is generally a time-consuming and labor-intensive operation. For example, printed circuit assemblies are generally configured to accommodate a relatively large quantity of components having socket-type installations. Thus, during a printed circuit assembly testing or assembly operation, electronic components must be manually installed into each available socket of the printed circuit assembly to verify the operational status of the printed circuit assembly. Further, manual installation of the electronic components into sockets of the printed circuit assembly generally results in a susceptibility of component misalignment with the socket, bent or broken pins on the component, and/or damage to the socket resulting from incorrectly locking the component to the socket.

### SUMMARY OF THE INVENTION

In accordance with one embodiment of the present invention, a printed circuit assembly system comprises an assembly module adapted to automatically insert an electronic component into a socket of the printed circuit assembly and automatically close the socket to secure the electronic component to the socket.

In accordance with one embodiment of the present invention, a printed circuit assembly method comprises automatically inserting an electronic component into a socket disposed on a printed circuit assembly and automatically closing the socket to secure the electronic component to the socket.

### BRIEF DESCRIPTION OF THE DRAWINGS

For a more complete understanding of the present invention and the advantages thereof, reference is now made to the following descriptions taken in connection with the accompanying drawings in which:

FIGURE 1 is a diagram illustrating an embodiment of a printed circuit assembly system in accordance with the present invention;

FIGURES 2A and 2B are diagrams illustrating an embodiment of a support tray of the printed circuit assembly system illustrated in FIGURE 1;

FIGURES 3A and 3B are diagrams illustrating an embodiment of a test assembly of the printed circuit assembly system illustrated in FIGURE 1;

FIGURES 4A-4C are diagrams illustrating an embodiment of an insert assembly of the printed circuit assembly system illustrated in FIGURE 1;

FIGURES 5A-5C are diagrams illustrating an embodiment of a central processing unit (CPU) cage assembly of the printed circuit assembly system illustrated in FIGURE 1;

FIGURES 6A-6C are diagrams illustrating an embodiment of a retention assembly of the printed circuit assembly system illustrated in FIGURE 1;

FIGURES 7A-7D are diagrams illustrating an embodiment of a base assembly of the printed circuit assembly system illustrated in FIGURE 1; and

FIGURES 8A-8E are diagrams illustrating an embodiment of a drive assembly of the printed circuit assembly system illustrated in FIGURE 1.

### DETAILED DESCRIPTION OF THE DRAWINGS

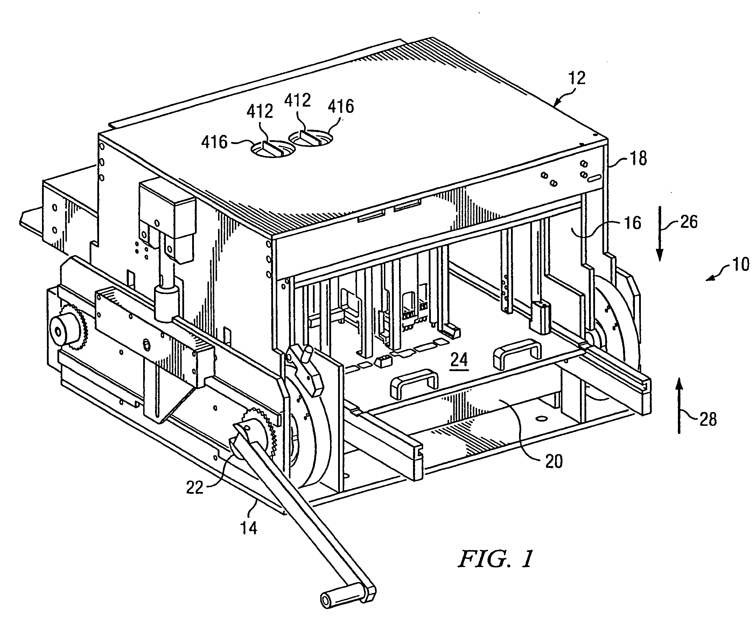

The preferred embodiments of the present invention and the advantages thereof are best understood by referring to FIGURES 1-8 of the drawings, like numerals being used for like and corresponding parts of the various drawings.

FIGURE 1 is a diagram illustrating an embodiment of a printed circuit assembly system 10 in accordance with the present invention. System 10 comprises an assembly module 12 for automatically inserting at least one electronic component into a socket disposed on a printed circuit assembly and automatically closing or locking the socket to secure the electronic component to the socket. The electronic component may comprise a central processing unit (CPU) or any other type of component adapted to cooperate with and/or be inserted into a socket. In the embodiment illustrated in FIGURE 1, assembly module 12 comprises a base assembly 14, an insert assembly 16, a retention assembly 18, a test assembly 20, a drive assembly 22, and a support tray 24. According to some embodiments of the present invention, a printed circuit assembly having at least one socket disposed thereon is placed upon support tray 24 and disposed within assembly module 12. Actuation of drive assembly 22 causes insert assembly 16 having an electronic component coupled thereto to move in the direction indicated generally at 26 toward the printed circuit assembly and engage the printed circuit assembly. Actuation of drive assembly 22 also causes insert assembly 16 to automatically lock the socket on the printed circuit assembly to secure the electronic component to the socket. Assembly module 12 is also configured to facilitate automatic opening or unlocking of sockets to enable removal of an electronic component from the socket.

In some embodiments of the present invention where testing of the printed circuit assembly is desired, actuation of drive assembly 22 further facilitates electrical engagement of various components on either or both sides of the printed circuit assembly. For example, in some embodiments, actuation of drive assembly 22 also causes test assembly 20 to move in the direction indicated generally at 28 toward the printed circuit assembly to automatically engage selected components of the printed circuit assembly disposed toward test assembly 20. Additionally, in some testing embodiment applications, insert assembly 16 is also configured to automatically engage selected components of the printed circuit assembly disposed toward insert assembly 16 in response to actuation of drive assembly 22. Further, in some testing embodiment applications of the present invention where subsequent removal of the electronic component from the socket is desired, reverse-actuation of drive assembly 22 causes insert assembly 16 to automatically unlock the socket to facilitate removal of the electronic component from the printed circuit assembly. Reverse-actuation of drive assembly 22 also causes insert assembly 16 and/or test assembly 20 to retract or move away from the printed circuit assembly to automatically disengage from components of printed circuit assembly. ,

Additionally, in some embodiments of the present invention where disengagement from components of the printed circuit assembly and/or removal of an electronic component from a socket of the printed circuit assembly is desired, retention assembly 18 restrains movement of the printed circuit assembly to facilitate the electrical disengagement and/or electronic component removal. For example, in some embodiments, actuation of drive assembly 22 also causes retention assembly 18 to move in the direction indicated by 26 to contact or otherwise engage the printed circuit assembly. Reverse-actuation of drive assembly 22 causes retraction of insert assembly 16 and/or test assembly 20 to electrically disengage from the printed circuit assembly while retention assembly 18 remains, at least temporarily, in contact with the printed circuit assembly, thereby preventing movement of the printed circuit assembly during electrical disengagement. Further reverse-actuation of drive assembly 22 causes retention assembly 18 to retract from the printed circuit assembly to facilitate removal of the printed circuit assembly from assembly module 12.

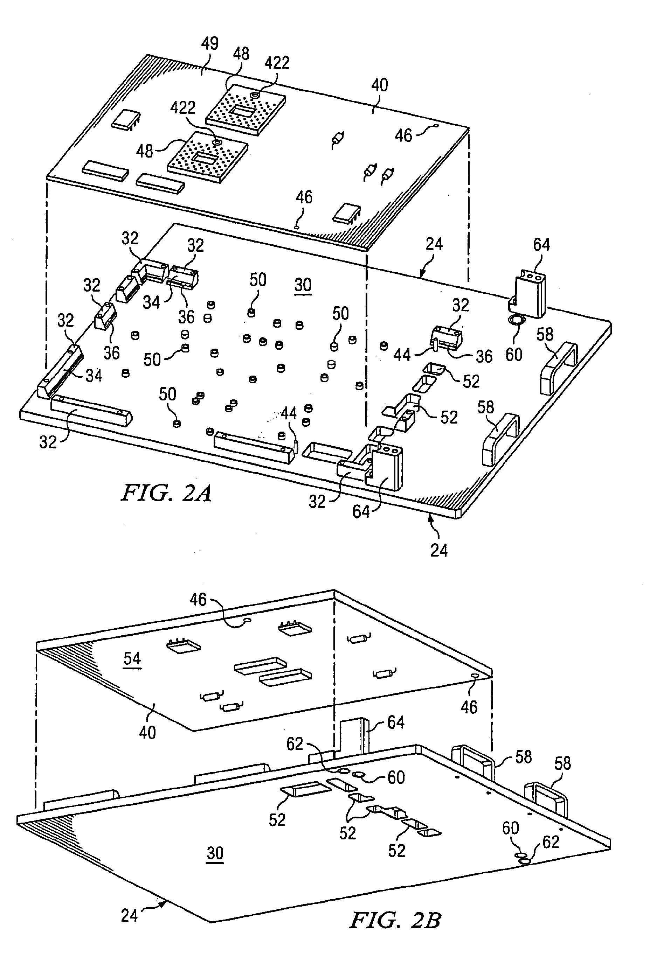

FIGURES 2A and 2B are diagrams illustrating an embodiment of support tray 24 in accordance with the present invention. In the embodiment illustrated in FIGURES 2A and 2B, support tray 24 comprises a generally planar support member 30 having guide members 32 disposed thereon to facilitate placement of a printed circuit assembly 40 on support tray 24. For example, in the embodiment illustrated in FIGURES 2A and 2B, each guide member 32 comprises a tapered surface 34 to facilitate alignment and placement of printed circuit assembly 40 onto support tray 24 such that support surfaces 36 of guide members 32 support a periphery of printed circuit assembly 40. It should be understood that a greater or fewer quantity of guide members 32 may be used on support tray 24 other than the quantity illustrated in FIGURES 2A and 2B.

The support tray 24 also comprises a plurality of guide pins 44 positioned to cooperate with corresponding openings 46 formed on printed circuit assembly 40 to align or register printed circuit assembly 40 within assembly module 12. For example, guide pins 44 are used to register a location of at least one socket 48 disposed on a side 49 of printed circuit assembly 40 to a location of a corresponding electronic component disposed on insert assembly 16 to facilitate insertion and locking and/or unlocking of the electronic component relative to socket 48. Registration of printed circuit assembly 40 by support tray 24 also facilitates electrical engagement of other components disposed on printed circuit assembly 40 by insert assembly 16 and/or test assembly 20. Socket 48 may comprise a zero insertion force (ZIF) socket or any other type of socket.

In the embodiment illustrated in FIGURES 2A and 2B, support tray 24 also comprises standoffs or support spacers 50 to support various locations of printed circuit assembly 40. Support tray 24 also comprises openings 52 extending therethrough to facilitate electrical engagement of printed circuit assembly 40 through support tray 24 by test assembly 20. For example, in some embodiments, actuation of drive assembly 22 causes test assembly 20 to move toward support tray 24 and to electrically engage components disposed on a side 54 of printed circuit assembly 40. Openings 52 formed in support tray 24 enable components disposed on side 54 of printed circuit assembly 40 to extend through support tray 24 to facilitate electrical engagement with such components by test assembly 20. Alternatively or additionally, openings 52 enable portions of test assembly 20 to extend through support tray 24 to facilitate electrical engagement with components disposed on side 54 of printed circuit assembly 40.

In the embodiment illustrated in FIGURES 2A and 2B, support tray 24 also comprises handles 58 to facilitate insertion and removal of support tray 24 relative to assembly module 12. Support tray 24 also comprises openings 60 and 62 formed in support member 30 and a plurality of guide rod stops 64 mounted to support member 30. The function of openings 60 and 62 and guide rod stops 64 will be described further below.

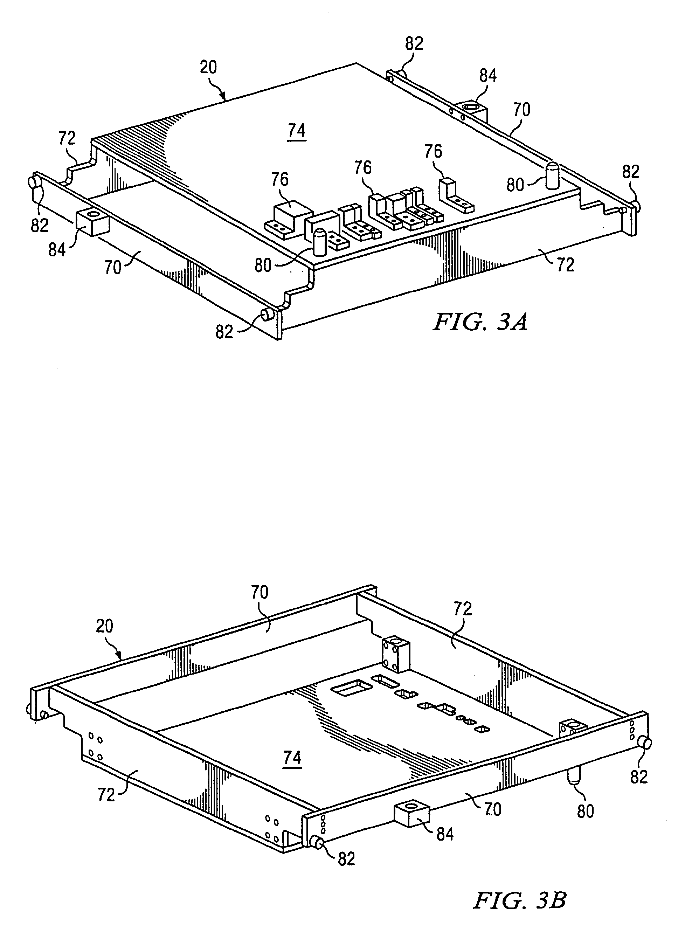

FIGURES 3A and 3B are diagrams illustrating an embodiment of test assembly 20 in accordance with the present invention. In the embodiment illustrated in FIGURES 3A and 3B, test assembly 20 comprises a plurality of longitudinal support members 70, a plurality of lateral support members 72, and a horizontal support member 74. Test assembly 20 also comprises electrical mounts 76 for electrically engaging particular components and/or areas of printed circuit assembly 40. For example, in operation, actuation of drive assembly 22 causes test assembly 20 to move toward printed circuit assembly 40 to facilitate engagement of mounts 76 to corresponding components and/or areas of printed circuit assembly 40. Thus, in some embodiments, test assembly 20 is used to enable testing of printed circuit assembly 40 by facilitating electrical engagement of various components and/or areas of printed circuit assembly 40 disposed on side 54 of printed circuit assembly 40, as illustrated in FIGURE 2B. Therefore, in the embodiment illustrated in FIGURES 3A and 3B, test assembly 20 is configured to enable mounts 76 to extend through openings 52 formed in support tray 24, as illustrated in FIGURES 2A and 2B, to electrically engage components disposed on side 54 of printed circuit assembly 40.

Referring to FIGURES 3A and 3B, test assembly 20 also comprises a plurality of guide rods 80 coupled to support member 74 and extending towards tray 24 within assembly module 12. In operation, guide rods 80 cooperate with openings 60 in support try 24, as illustrated in FIGURES 2A and 2B, to align or register a location of test assembly 20 with a location of printed circuit assembly 40 within assembly module 12. In the embodiment illustrated in FIGURES 3A and 3B, test assembly 20 also comprises a plurality of roller bearings 82 and a guide 84 coupled to each support member 70. The function of roller bearings 82 and guides 84 will be described further below.

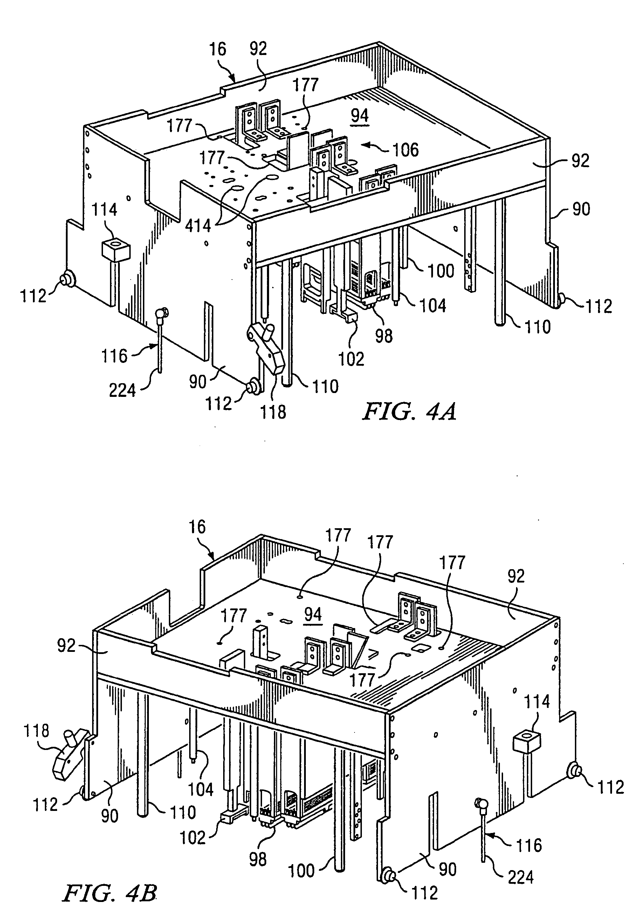

FIGURES 4A-4C are diagrams illustrating an embodiment of insert assembly 16 in accordance with the present invention. In the embodiment illustrated in FIGURES 4A-4C, insert assembly 16 comprises a plurality of longitudinal support members 90, a plurality of lateral support members 92, and a horizontal support member 94. In some embodiments, insert assembly 16 also comprises components for electrically engaging printed circuit assembly 40 for performing testing operations on printed circuit assembly 40. For example, in the embodiment illustrated in FIGURES 4A-4C, insert assembly 16 comprises memory module support assemblies 98, input/output (I/O) assemblies 100, cable clamp assemblies 102, and ECI rods 104 for facilitating electrical communications with printed circuit assembly 40. For example, assemblies 98, 100 and 102 and external call interface (ECI) rods 104 are coupled to support member 94 such that connections to various components on printed circuit assembly 40 may be made via corresponding interfaces, indicated generally at 106, on support member 94. It should also be understood that various other types of components may be coupled to insert assembly 16 to accommodate a desired testing operation of printed circuit assembly 40 such as, but not limited to, peripheral component interface (PCI) cards, input/output (I/O) boards, and dual inline memory modules (DIMMs). Thus, in some embodiments, actuation of drive assembly 22 causes insert assembly 16 to move toward and electrically engage printed circuit assembly 40 to facilitate testing operations of printed circuit assembly 40.

In the embodiment illustrated in FIGURES 4A-4C, insert assembly 16 also comprises a plurality of guide rods 110 for cooperating with guide rod stops 64 of support tray 24, as illustrated in FIGURES 2A and 2B. For example, in operation, guide rods 110 cooperate with guide rod stops 64 to align or register insert assembly 16 with printed circuit assembly 40 disposed on support tray 24. Actuation of drive assembly 22 causes insert assembly 16 to move towards printed circuit assembly 40 as guide rods 110 of insert assembly 16 cooperate with guide rod stops 64 and openings 62 of support tray 24.

In the embodiment illustrated in FIGURES 4A-4C, insert assembly 16 also comprises a plurality of roller bearings 112, a guide 114, and a spring assembly 116 coupled to each support member 90. In the embodiment illustrated in FIGURES 4A-4C, insert assembly 16 comprises a locking assembly 118 coupled to one of support members 90. However, it should be understood that system 10 may also be configured without locking system 18.

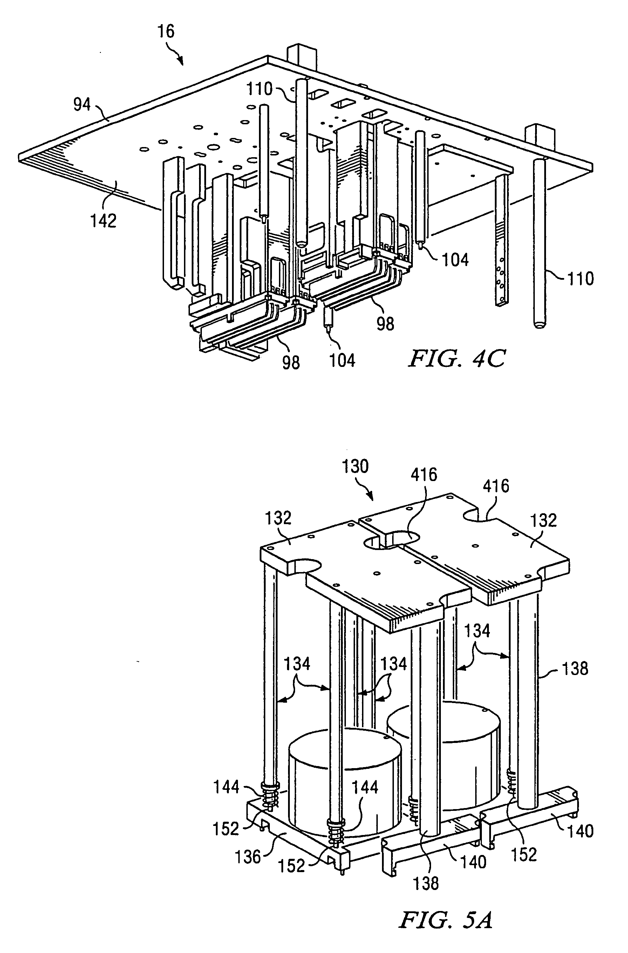

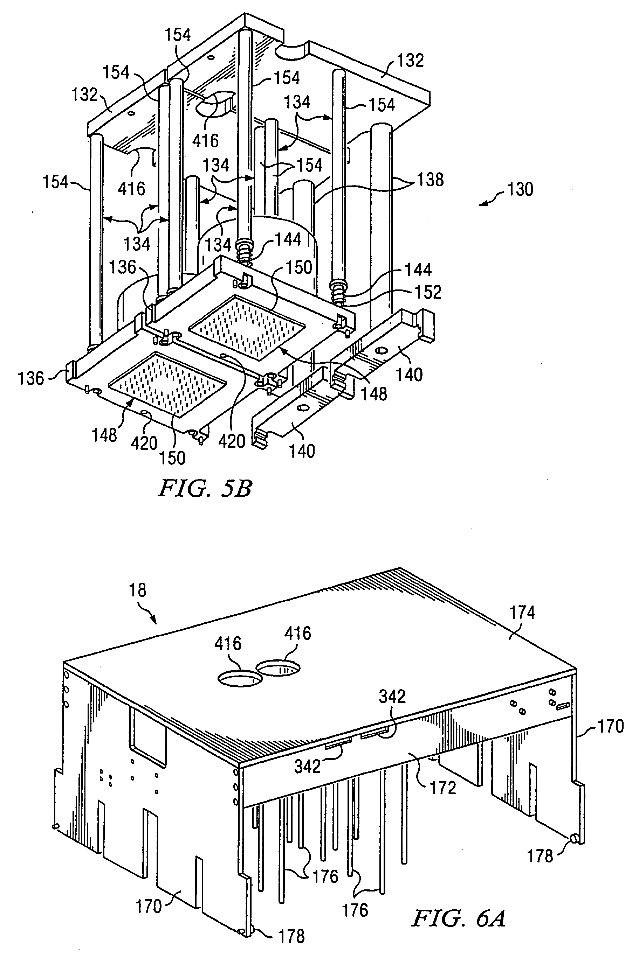

FIGURES 5A-5C are diagrams illustrating an embodiment of a cage assembly 130 in accordance with the present invention. Two cage assemblies 130 are illustrated in FIGURES 5A-5C. However, it should be understood that a greater or fewer quantity of cage assemblies 130 may be used in system 10 to facilitate engagement of a particular quantity of electronic components to corresponding sockets 48. Additionally, it should be understood that a single cage assembly 130 may be configured to facilitate engagement of multiple electronic components to sockets 48. Referring to FIGURES 5A and 5B, each cage assembly 130 comprises a mounting plate 132, rods 134 coupled to mounting plate 132, a cooling assembly 136 coupled to rods 134, a power rod assembly 138 coupled to mounting plate 132, and a power mount assembly 140 coupled to power rod assembly 138. Cooling assembly 136 may comprise a heatsink or any other type of device to facilitate cooling or thermal energy dissipation of an electronic component. Mounting plate 132 is coupled to a side 142 of support member 94 of insert assembly 16, as illustrated in FIGURE 4C, such that cooling assembly 136 and an electronic component 148 mounted to cooling assembly 136 are disposed toward printed circuit assembly 40. In the embodiment illustrated in FIGURES 5A-5C, and for the remaining description herein, but not by way of limitation, electronic component 148 comprises a central processing unit (CPU) 150. CPU 150 may be coupled to cooling assembly 136 via a variety of different types of devices such as, but not limited to, a clip, a strap, a retaining bracket, or an adhesive or bonding agent. Additionally, in some embodiments, assembly module 12 is configured to facilitate release of CPU 150 after locking of CPU 150 in socket 48. For example, if testing of printed circuit assembly 40 is not desired or a "production" installation of CPU 150 into socket 48 is desired, CPU 150 may be releasably coupled to insert assembly 16 via a releasable clip or other type of device or method to facilitate release or disengagement of CPU 150 from insert assembly 16 after locking of CPU 150 in socket 48.

Referring to FIGURES 5A and 5B, each rod 134 comprises a spring assembly 144 disposed between cooling assembly 136 and a spacer 146. In operation, actuation of drive assembly 22 causes insert assembly 16 and cage assembly 130 to move toward printed circuit assembly 40 to facilitate engagement of CPU 150 with a corresponding socket 48 on printed circuit assembly 40. As will be described further below, actuation of drive assembly 22 also automatically locks socket 48 to secure CPU 150 to socket 48. In some embodiments, after locking of socket 48, actuation of drive assembly 22 causes continued movement of insert assembly 16 toward printed circuit assembly 40 to facilitate electrical engagement of components on printed circuit assembly 40 by insert assembly 16. Rods 134 are configured to enable such continued movement of insert assembly 16 while applying a predetermined compressive force to CPU 150. For example, in the embodiment illustrated in FIGURES 5A and 5B, each rod 134 comprises a lower cylindrical member 152 slidably coupled to an upper cylindrical member 154. Thus, during such continued movement of insert assembly 16 toward printed circuit assembly 40, movement of member 154 relative to member 152 and cooling assembly 136 compresses spring assemblies 144, thereby applying a predetermined compressive force to CPU 150 in socket 48. In some embodiments, power rod assembly 138 and power mount assembly 140 are adapted to engage printed circuit assembly 40 to provide a power supply to CPU 150 to facilitate testing of printed circuit assembly 40 with CPU 150. However, it should also be understood that assembly module 12 may also be configured without power rod assembly 138 and power mount assembly 140 to facilitate other applications. For example, if testing of printed circuit assembly 40 is not desired, assembly module 12 may be configured without power rod assembly 138 and power mount assembly 140.

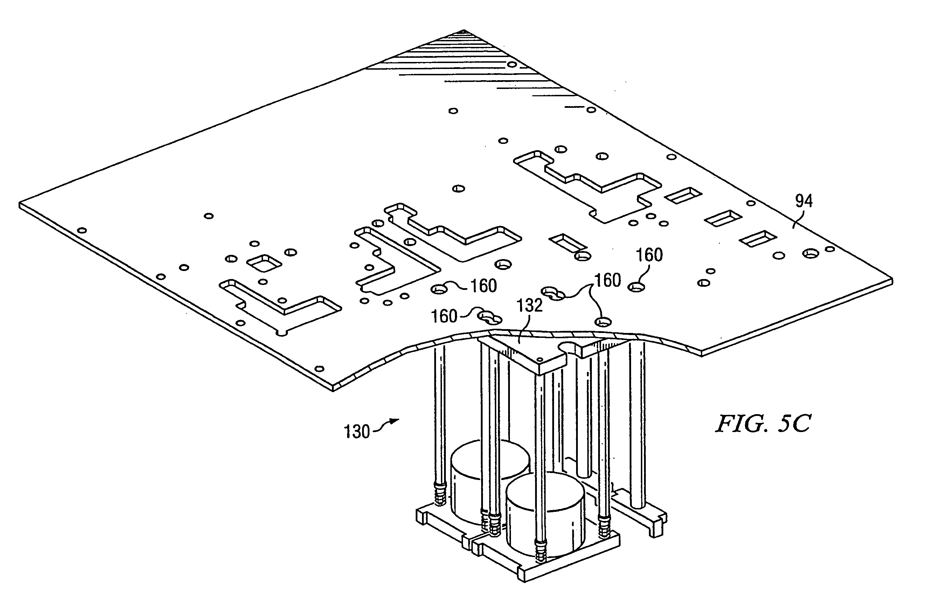

Referring to FIGURE 5C, an interface between support member 94 of insert assembly 16 and each cage assembly 130 is illustrated. In some embodiments, sockets 48 are configured to translate to lock CPU 150 in socket 48 (e.g., 0.030 inch translational movement). Thus, in some embodiments, cage assembly 130 is coupled to support member 94 to enable translational movement of cage assembly 130 to facilitate locking of socket 48. For example, in the embodiment illustrated in FIGURE 5C, mounting plate 132 of each cage assembly 130 is movably coupled to support member 94 via openings 160 formed in support member 94. Openings 160 are formed having a circular or non-circular configuration sized to enable a coupling element, such as a shoulder bolt or other type of fastener, to translate within opening 160, thereby enabling translational movement of cage assembly 130 relative to support member 94 to facilitate a corresponding translational movement of socket 48 during locking of socket 48 and/or location adjustment of CPU 150 relative to socket 48. However, it should be understood that other devices or methods may be used to enable translational movement of cage assembly 130 relative to support member 94.

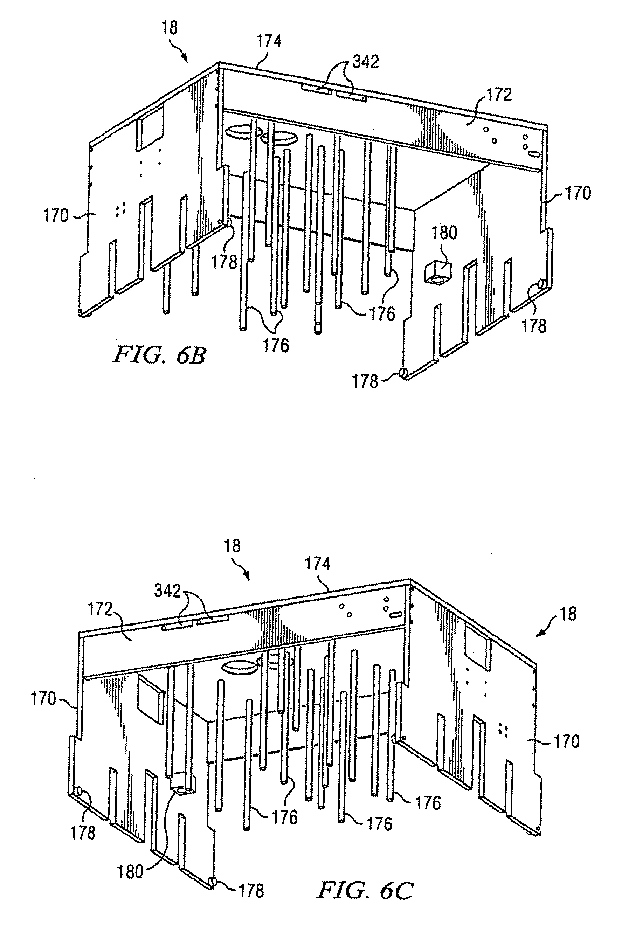

FIGURES 6A-6C are diagrams illustrating an embodiment of retention assembly 18 in accordance with the present invention. In the embodiment illustrated in FIGURES 6A and 6B, retention assembly 18 comprises a plurality of longitudinal support members 170, a plurality of lateral support members 172, and a horizontal support member 174. Retention assembly 18 also comprises a plurality of retention rods 176 coupled to support member 174 and extending through openings 177 formed in support member 94 of insert assembly 16, as illustrated in FIGURES 4A and 4B, toward printed circuit assembly 40. In operation, actuation of drive assembly 22 moves retention assembly 18 toward printed circuit assembly 40 such that retention rods 176 contact or otherwise engage areas of printed circuit assembly 40. In some embodiments, to facilitate electrical disengagement of insert assembly 16 and/or test assembly 20 from printed circuit assembly 40, retention assembly 18 remains in contact with printed circuit assembly 40 to restrain printed circuit assembly 40 during electrical disengagement. Thus, in operation, retention assembly 18 remains substantially stationary while insert assembly 16 and/or test assembly 20 retract from printed circuit assembly 40, thereby restraining printed circuit assembly 40 within assembly module 12 in a relatively fixed position to facilitate electrical disengagement of insert assembly 16 and/or test assembly 20 from printed circuit assembly 40. In the embodiment illustrated in FIGURES 6A-6C, retention assembly 18 also comprises a plurality of roller bearings 178 and a guide 180 coupled to an internal surface of each support member 170. The function of roller bearings 178 and guides 180 will be described further below.

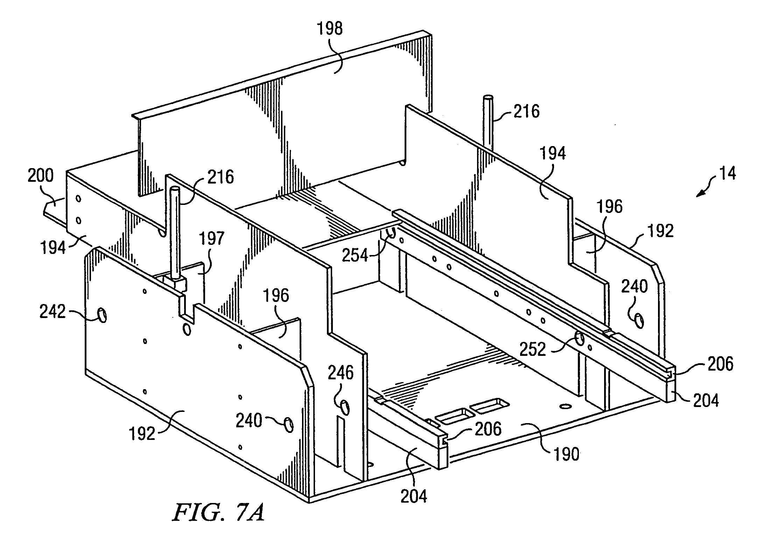

FIGURES 7A-7D are diagrams illustrating an embodiment of base assembly 14 in accordance with the present invention. In the embodiment illustrated in FIGURES 7A-7D, base assembly 14 comprises a base support member 190, a plurality of bearing support members 192, a plurality of longitudinal support members 194, spaced-apart gussets 196 and 197 extending between each support member 192 and support member 194, a cover 198, and a drive cage support assembly 200. Base assembly 14 also comprises a plurality of rails 204 coupled to support members 194 to support and enable slidable insertion and removal of support tray 24 from assembly module 12. For example, in operation, support tray 24 is disposed within a guide channel 206 formed in each guide rail 204 to enable slideable movement of support tray 24 relative to guide rails 204. However, it should be understood that other devices or methods may be used to enable insertion and removal of support tray 24 relative to assembly module 12.

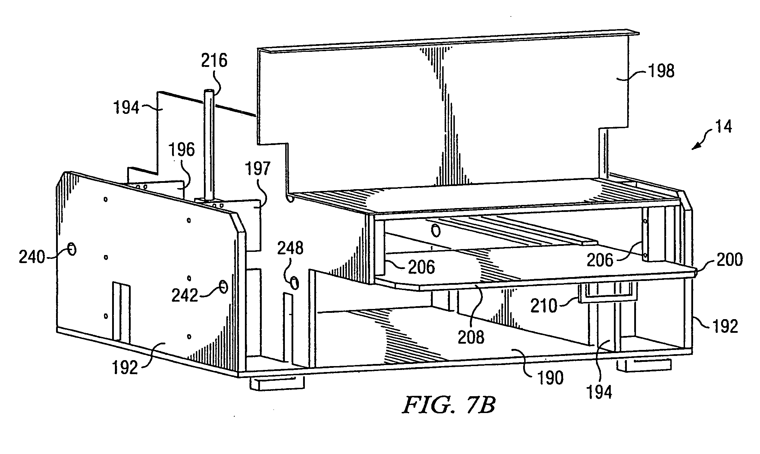

Referring to FIGURE 7B, drive cage support assembly 200 is adapted to facilitate electrical engagement to desired components of printed circuit assembly 40 via a rearward portion of assembly module 12. For example, as illustrated in FIGURE 7B, base assembly 14 is configured to enable rearward access to printed circuit assembly 40 disposed within assembly module 12. In the embodiment illustrated in FIGURE 7B, drive cage support assembly 200 comprises a plurality of spaced-apart drive cage mounts 206 and a drive cage support member 208 to facilitate connection of a drive cage device or assembly to a rearward portion of printed circuit assembly 40. In the embodiment illustrated in FIGURE 7B, drive cage support assembly 200 also comprises a power plug mount 210 adapted to receive and support a power supply interface for supplying power to printed circuit assembly 40. It should also be understood that base assembly 14 may be otherwise configured to enable access and engagement of various locations of printed circuit assembly 40 by various devices to perform testing or other types of operations relative to printed circuit assembly 40.

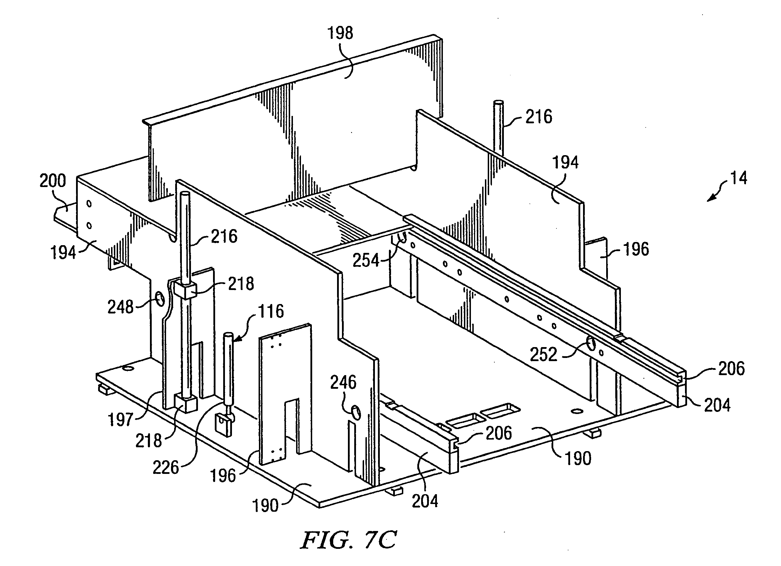

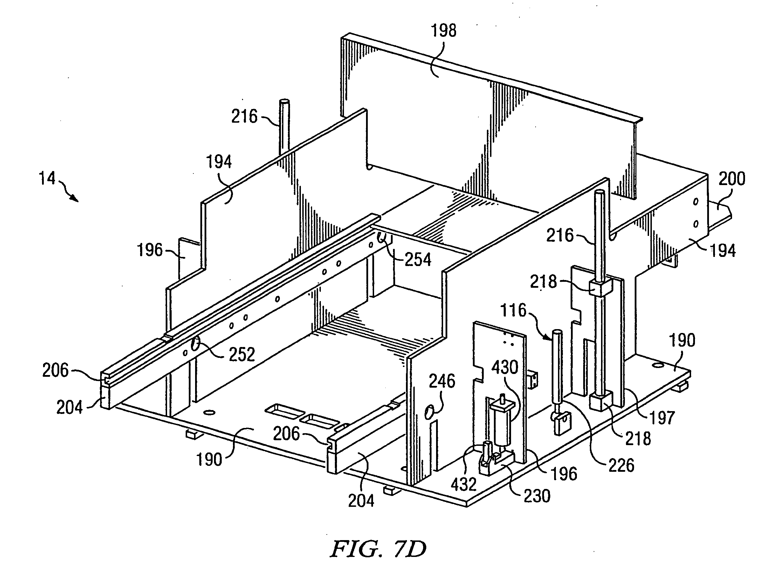

Referring to FIGURES 7C and 7D, base assembly 14 is illustrated without support members 192. In the embodiment illustrated in FIGURES 7C and 7D, base assembly 14 comprises a guide rod 216 coupled to each gusset 197 via a plurality of guide rod mounts 218. In operation, guide rods 216 extend through guides 84 of test assembly 20, as illustrated in FIGURES 3A and 3B, into guides 114 of insert assembly 16, as illustrated in FIGURES 4A and 4B, and into guides 180 disposed on retention assembly 18, as illustrated in FIGURES 6B and 6C. Thus, in operation, actuation of drive assembly 22 causes insert assembly 16, retention assembly 18, and test assembly 20 to move along guide rods 216 relative to printed circuit assembly 40.

In the embodiment illustrated in FIGURES 7C and 7D, a lower portion of spring assembly 116 is coupled to base support member 190. In operation, referring to FIGURES 4A-4B and 7C-7D, spring assembly 116 comprises an upper portion 224 coupled to each support member 90 of insert assembly 16 and a lower portion 226 coupled to base assembly 14. In operation, spring assembly 16 is adapted to support a weight of insert assembly 16 such that the weight of insert assembly 16 is not supported entirely by drive system 22. Spring assembly 116 may be configured using pneumatic, mechanical (e.g., springs), or any other type of devices for supporting a weight of insert assembly 16. However, it should also be understood that other devices or methods may be used to support a weight of insert assembly 16 to facilitate movement of insert assembly 16 relative to printed circuit assembly 40.

Referring to FIGURES 7A-7D, base assembly 14 also comprises a lock assembly 230 coupled to one of gussets 196. In operation, lock assembly 230 prevents disengagement of insert assembly 16 and/or test assembly 20 from printed circuit assembly 40 during electrical engagement of printed circuit assembly 40 to prevent damage to printed circuit assembly 40 that may result from inadvertent electrical disengagement of printed circuit assembly 40 while power is supplied to printed circuit assembly 40. The operation of lock assembly 230 will be described further below. Referring to FIGURES 7A-7D, base assembly 14 also comprises openings 240 and 242 formed in each support member 192, openings 246 and 248 formed in each support member 194, and openings 252 and 254 formed in each rail 204. The function of openings 240, 242, 246, 248, 252, and 254 will be described further below.

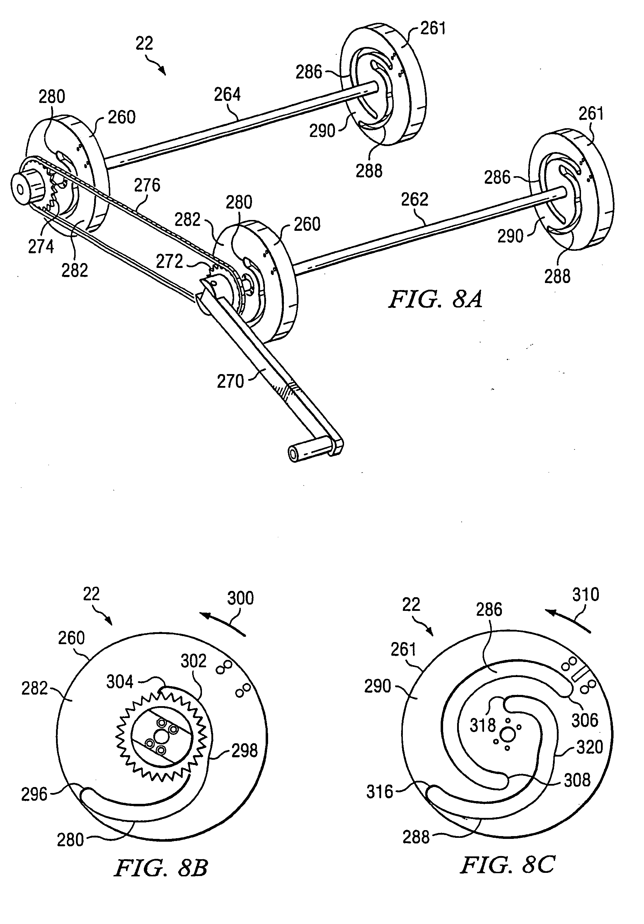

FIGURES 8A-8E are diagrams illustrating an embodiment of drive assembly 22 in accordance with the present invention. In the embodiment illustrated in FIGURES 8A-8E, drive assembly 22 comprises cams 260 and 261 fixedly coupled to opposite ends of each of a drive shaft 262 and 264. In the embodiment illustrated in FIGURES 8A-8E, cams 261 are formed as a mirrored configuration of cams 260. In operation, referring also to FIGURES 7A-7D, drive shafts 262 and 264 are rotatably supported by base assembly 14. For example, drive shaft 262 extends through openings 240, 246, and 252, and drive shaft 264 extends through openings 242, 248, and 254. Thus, in operation, drive shafts 262 and 264 are rotateably coupled to base assembly 14 to enable rotation of cams 260 relative to base assembly 14.

Referring to FIGURE 8A, drive assembly 22 also comprises a handle 270 fixedly coupled to one end of drive shaft 262, a sprocket 272 coupled to one end of drive shaft 262 proximate to handle 270, and a sprocket 274 coupled to a corresponding end of drive shaft 264. A drive chain 276 extends between and engages each of sockets 272 and 274. Thus, in operation, actuation of drive assembly 22 via handle 270 causes rotation of drive shafts 262 and 264 and, correspondingly, rotation of each of cams 260 and 261. In the embodiment illustrated in FIGURE 8A, drive assembly 22 is actuated via handle 270 by a user. However, it should be understood that drive assembly 22 may also be configured to enable electrically-, pneumatically- and/or computer-controlled actuation.

Referring to FIGURES 8A-8C, each cam 260 and 261 comprises a groove 280 formed on an exterior surface 282 thereof, and grooves 286 and 288 formed on an interior surface 290 thereof. For example, FIGURE 8B is a diagram illustrating an exterior view of cam 260, and FIGURE 8C is a diagram illustrating an interior view of cam 261. In the embodiment illustrated in FIGURES 8A-8C, cams 260 and 261 are used to produce a predetermined distance, rate and sequence of movement of insert assembly 16, retention assembly 18, and test assembly 20 relative to printed circuit assembly 40. However, it should be understood that other types of devices or methods may be used to provide movement of insert assembly 16, retention assembly 18, and test assembly 20 relative to printed circuit assembly 40.

In operation, drive assembly 22 controls movement of insert assembly 16, retention assembly 18, and/or test assembly 20 via cams 260 and 261. For example, referring to FIGURES 8A-8B and 6A-6C, roller bearings 178 of retention assembly 18 are disposed in groove 280 of cams 260 and 261 such that, in response to rotation of cams 260 and 261, roller bearings 178 follow a predetermined movement rate, distance and sequence relative to printed circuit assembly 40 and relative to insert assembly 16 and test assembly 20. For example, in the embodiment illustrated in FIGURE 8B, groove 280 extends from a peripheral region 296 inwardly toward a central region 298, thereby producing movement of retention assembly 18 relative to printed circuit assembly 40 in response to rotation of cams 260 and 261 as roller bearings 178 travel within groove 280 between region 296 and region 298. Thus, rotation of cams 260 and 261 in the direction indicated by 300 in FIGURE 8B causes roller bearings 178 to travel within groove 280 from region 298 to region 296, thereby producing movement of retention assembly 18 away from printed circuit assembly 40 in a direction indicated by 28 of FIGURE 1. Accordingly, rotation of cams 260 and 261 in a direction opposite that indicated by 300 causes movement of retention assembly 18 toward printed circuit assembly 40 in a direction indicated by 26 of FIGURE 1.

In the embodiment illustrated in FIGURE 8B, groove 280 also comprises an idle region 302 disposed at a generally constant concentric position extending from region 298 to region 304 to maintain an idle or stationary position of retention assembly 18 relative to printed circuit assembly 40 during rotation of cams 260 and 261. For example, during disengagement of insert assembly 16 and/or test assembly 20 from printed circuit assembly 40, idle region 302 enables retention assembly 18 to remain in contact with printed circuit assembly 40 while insert assembly 16 and/or test assembly 20 retract and disengage from printed circuit assembly 40 in response to rotational movement of cams 260 and 261. Additionally, idle region 302 enables retention assembly 18 to remain in a substantially stationary position relative to printed circuit assembly 40 while insert assembly 16 and/or test assembly 20 continue movement toward printed circuit assembly 40 to electrically engage printed circuit assembly 40 in response to rotation of cams 260 and 261.

Referring to FIGURES 8A, 8C and 3A-3B, roller bearings 82 of test assembly 20 engage and cooperate with groove 286 of cams 260 and 261 to produce a desired rate, sequence and distance of movement of test assembly 20 relative to printed circuit assembly 40 and relative to insert assembly 16 and retention assembly 18. For example, referring to FIGURE 8C, groove 286 extends from a peripheral region 306 to a central region 308, thereby producing movement of test assembly 20 relative to printed circuit assembly 40 in response to rotation of cams 260 and 261. Thus, in operation, rotation of cams 261 and 260 in the direction indicated by 310 of FIGURE 8C causes roller bearing 82 to travel within groove 286 from region 308 to region 306, thereby moving test assembly 20 away from printed circuit assembly 40 in the direction indicated by 26 of FIGURE 1. Correspondingly, rotation of cams 261 and 260 in the direction opposite that indicated by 310 of FIGURE 8C causes movement of test assembly 20 toward printed circuit assembly 40 in the direction indicated by 28 of FIGURE 1.

Referring to FIGURES 8A, 8C and 4A-4B, roller bearings 112 of insert assembly 16 engage and cooperate with groove 288 of cams 261 and 260 to provide a desired rate, sequence and distance of movement of insert assembly 16 relative to printed circuit assembly 40 and relative to test assembly 20 and retention assembly 18. For example, in the embodiment illustrated in FIGURE 8C, groove 288 extends from a peripheral region 316 to a central region 318, thereby producing movement of insert assembly 16 relative to printed circuit assembly 40 in response to rotation of cams 261 and 260 as roller bearings 112 travel within groove 288 between region 316 and region 318 . Thus, in operation, rotation of cams 261 and 260 in the direction indicated generally by 310 of FIGURE 8C causes movement of insert assembly 16 away printed circuit assembly 40, in the direction indicated by 28 of FIGURE 1, as roller bearings 112 move from region 318 of groove 288 to region 316 of groove 288. Correspondingly, rotation of cams 261 and 260 in a direction opposite that indicated by 310 of FIGURE 8C causes movement of insert assembly toward printed circuit assembly 40 in the direction indicated by 26 of FIGURE 1.

Additionally, in the embodiment illustrated in FIGURE 8C, groove 288 comprises an idle region 320 to maintain an idle or stationary position of insert assembly 16 relative to printed circuit assembly 40 during continued rotation of cams 261 and 260. For example, in operation, groove 288 is configured to maintain insert assembly 16 in a stationary position relative to printed circuit assembly 40 while CPU 150 is locked to a corresponding socket 48 while roller bearings 112 are within idle region 320 of groove 288. After CPU 150 is locked to a corresponding socket 48, groove 288 provides additional movement of insert assembly 16 towards printed circuit assembly 40 to enable electrical engagement of insert assembly 16 with printed circuit assembly 40 and/or apply a predetermined level of compressive force to printed circuit assembly 40 to, for example, electrically engage various components of printed circuit assembly 40 and/or maintain a predetermined compressive force applied to CPU 150.

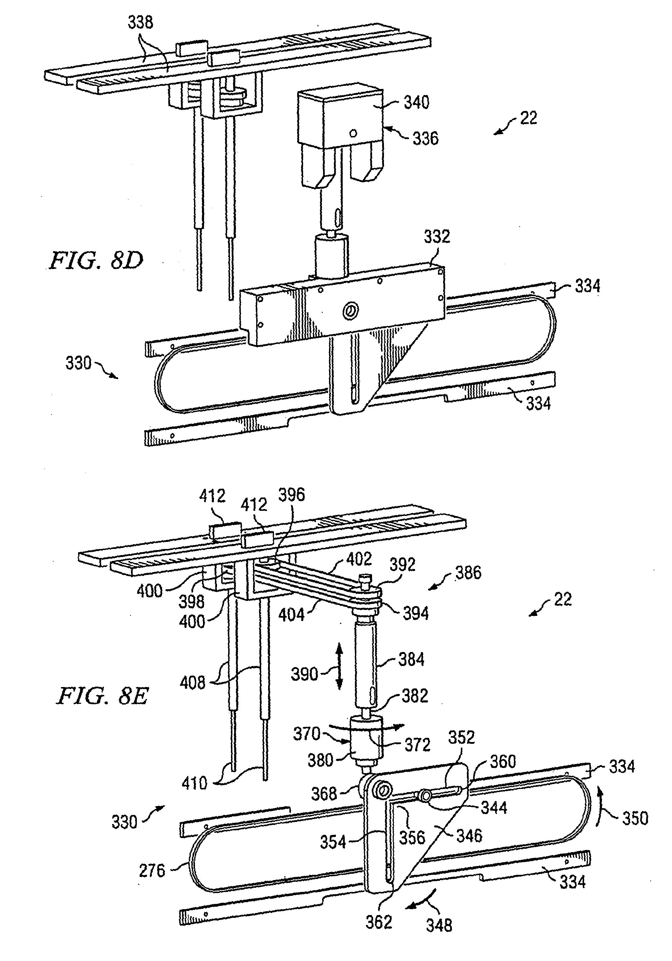

FIGURES 8D and 8E are diagrams illustrating a socket drive assembly 330 of drive assembly 22 in accordance with the present invention. In the embodiment illustrated in FIGURES 8D and 8E, socket drive assembly 330 comprises a cam support member 332 coupled to support member 192 of base assembly 14, a plurality of chain guard members 334, a gear box assembly 336 coupled to support member 170 of retention assembly 18 via a support member 340, and a plurality of support members 338 extending longitudinally between support members 172 of retention assembly 18 and into openings 342 formed by support members 172 and support member 174 of retention assembly 18, as illustrated in FIGURES 6A-6C. In the embodiment illustrated in FIGURES 8D and 8E, two support members 338 are illustrated corresponding to two CPU 150 and socket 48 engagement locations. However, it should be understood that a lesser or greater quantity of support members 338 may be used to accommodate additional or fewer CPU 150 and socket 48 engagement locations.

Referring to FIGURE 8E, socket drive assembly 330 is illustrated without cam support member 332 and support member 340. In the embodiment illustrated in FIGURE 8E, socket drive assembly 330 comprises a roller member 344 and a cam 346. Cam 346 is rotatably coupled to support member 332 to enable rotational movement of cam 346 in the direction indicated generally at 348. Roller member 344 is fixedly coupled to drive chain 276 and is adapted to cooperate with cam 346 to cause rotational movement of cam 346 in the direction indicated at 348 in response to movement of drive chain 276 in the direction indicated generally at 350. For example, in the embodiment illustrated in FIGURE 8E, cam 346 comprises slots 352 and 354 disposed at a desired angular orientation relative to each other and intersecting at a central region 356 of cam 346. In operation, in response to movement of drive chain 276 and the direction indicated at 350, roller member 344 translates within groove 352 beginning at or near an end 360 of groove 352 and moves toward central region 356 of groove 352. Continued movement of drive chain 276 in the direction indicated at 350 causes roller member 344 to transition from slot 352 to slot 354, thereby causing rotation of cam 346 in the direction indicated generally at 348 such that groove 354 gradually rotates in the direction indicated at 348 from the illustrated vertical position to a substantially horizontal position generally coincident with an upper portion of drive chain 276 as roller member 344 travels within slot 354 from central region 356 toward an end region 362. Thus, the cooperation of drive chain 276, roller member 344, and cam 346 causes rotation of cam 346 in the direction indicated generally at 348 by a desired angular rotation based on the angular positions of slots 352 and 354 relative to each other. For example, in some embodiments of the present invention, slots 352 and 354 are configured having a perpendicular (i.e., perpendicular or substantially perpendicular) angular relationship to each other to produce approximately 90° of angular rotation of cam 346. However, it should be appreciated that rotation of cam 346 does not necessarily have to be 90° (i.e., the cooperation and/or configuration of drive chain 276, roller member 344 and/or cam 346 may be otherwise modified to produce a desired angular rotation of cam 346).

In the embodiment illustrated in FIGURE 8E, socket drive assembly 330 also comprises a bevel gear assembly 368 adapted to convert rotational movement of cam 346 in the direction indicated at 348 to rotational movement of a wrench assembly 370 in the direction indicated generally at 372. Wrench assembly 370 comprises a wrench bearing member 380, a wrench drive shaft 382 coupled to bearing member 380, a wrench drive shaft 384 translationally coupled to drive shaft 382, and a sprocket assembly 386 coupled to drive shaft 384. In the embodiment illustrated in FIGURE 8E, drive shaft 384 is movably coupled to drive shaft 382 to accommodate movement of drive shaft 384 and sprocket assembly 386 relative to drive shaft 382 corresponding to movement of retention assembly 18 in the directions indicated at 26 and 28 of FIGURE 1. For example, referring to FIGURE 8E, drive shaft 382 and an interior portion of drive shaft 384 may be configured having complementary geometric configurations such that rotation of drive shaft 382 in the direction indicated at 372 causes corresponding rotation of drive shaft 384 in the direction indicated at 372 while enabling translating motion of drive shaft 384 relative to drive shaft 382 in the directions indicated generally at 390.

In the embodiment illustrated in FIGURE 8E, sprocket assembly 386 comprises two sprockets 392 and 394 coupled respectively to sprockets 396 and 398, each sprocket 396 and 398 disposed in a sprocket support member 400, via respective drive chains 402 and 404. Each sprocket 396 and 398 is coupled to a hex wrench support member 408 supporting a hex wrench 410 disposed at an end thereof. Additionally, an indicator 412 is coupled to each support member 408 at an end of support member 408 opposite hex wrench 410 and extends through, or is otherwise visible through, openings 416 formed in support member 174 of retention assembly 18, as illustrated in FIGURE 6A and 1. Support members 408 extend through openings 414 formed in support member 94 of insert assembly 16, as illustrated in FIGURE 4A, and through openings 416 formed in mounting plates 132 of CPU cage assembly 130, as illustrated in FIGURES 5A and 5B, toward printed circuit assembly 40.

In operation, hex wrenches 410 extend toward printed circuit assembly 40 and pass through openings 420 formed in cooling assembly 136, as illustrated in FIGURE 5B, to engage a corresponding hex key 422 of each socket 48, as illustrated in FIGURE 2A. For example, in the embodiment illustrated in FIGURES 2A and 8D-8E, sockets 48 are configured having hex keys 422 such that rotation of hex keys 422 locks or unlocks socket 48. However, it should be understood that system 10 may be configured to accommodate other types of socket 48 locking configurations.

Referring to FIGURES 8D-8E, in operation, movement of drive chain 276 in the direction indicated by 350 causes roller member 344 to move within, groove 352 toward region 356. At region 356, roller member 344 transitions to groove 354 of cam 346, thereby causing rotation of cam 346 in the direction indicated by 348. Rotation of cam 346 causes corresponding rotation of bevel gear assembly 368 to rotate wrench drive shafts 382 and 384 in the direction indicated at 372. In some embodiments, approximately 180° of rotation of hex key 422 of socket 48 is generally required to lock or unlock socket 48. Thus, in some embodiments, bevel gear assembly 368 is configured having a desired gear ratio to produce approximately 180° of rotational movement of drive shafts 382 and 384 in response to approximately 90° rotation of cam 346. Thus, rotation of drive shafts 384 and 382 is transmitted to hex wrenches 410 via sprockets 392 and 394, drive chains 402 and 404, and sprockets 396 and 398, thereby causing rotation of hex wrenches 410 by approximately 180° to unlock sockets 48 via hex keys 422 of sockets 48. Correspondingly, movement of drive chain 276 in a direction opposite that indicated by 350 causes rotation of hex wrenches 410 to lock sockets 48. However, it should be appreciated that system 10 may be otherwise configured to produce different amounts of angular rotation of hex wrenches 410 corresponding to a desired application or a predefined locking/unlocking criteria for a particular socket 48 (i.e., bevel gear assembly 368 may be otherwise configured to produce a desired amount of angular rotation of hex wrenches 410 and/or the cooperation of drive chain 276, roller member 344 and cam 346 may be otherwise configured to result in a desired angular rotation of hex wrenches 410). Additionally, rotation of hex wrenches 410 causes corresponding rotation of indicators 412 to enable a user to visually verify a locked/unlocked condition of CPU 150 within socket 48. For example, as illustrated in FIGURE 1, indicators 412 extend through openings 416 of retention assembly 18 to enable visual verification of a locked/unlocked condition of CPU 150 within socket 48.

Referring to FIGURES 4A-4B and 8A-8C, locking assembly 118 is configured to prevent inadvertent actuation of drive assembly 22. For example, in the embodiment illustrated in FIGURES 4A-4B and 8A-8C, locking assembly 118 is rotatably coupled to support member 90 proximate to a location of one of cams 260 such that locking assembly 118 releasably engages one of cams 260 to prevent rotation of the engaged cam 260, thereby preventing actuation of drive assembly 22. Locking assembly 118 may be configured having a pin, rod, brake element, or other type of structure for releasably engaging one of cams 260 to prevent rotation of cam 260. However, it should be understood that locking assembly 118 and/or one of cams 260 may be otherwise configured,to facilitate releasable engagement thereof to prevent rotation of one of cams 260. Additionally, it should be understood that other devices or methods may also be used to prevent inadvertent actuation of drive assembly 22. It should also be understood that locking assembly 118 may be used to suspend actuation of drive assembly 22 to facilitate one or more intermittent assembly or other types of operations relative to printed circuit assembly 40.

Referring to FIGURES 7D and 8A-8C, lock assembly 230 is configured to prevent inadvertent disengagement of test assembly 20 and/or insert assembly 16 from printed circuit assembly 40 while power is supplied to printed circuit assembly 40 (e.g., during testing or other operations). In the embodiment illustrated in FIGURES 7D and 8A-8C, lock assembly 230 comprises a solenoid valve 430 and a locking element 432 coupled to solenoid valve 430 and adapted to releasably engage one of cams 260 located proximate to locking element 432. In operation, solenoid valve 230 is configured such that, in response to power supplied to printed circuit assembly 40, solenoid valve 230 causes engagement of locking element 432 with one of cams 261 to prevent rotation of the engaged cam 261, thereby preventing actuation of drive assembly 22. Locking element may comprise a pin, rod, brake element or other type of structure for releasably engaging one of cams 261 to prevent rotation of the engaged cam 261. However, it should be understood that lock assembly 230 and/or one of cams 261 may be otherwise configured to facilitate releasable engagement thereof to prevent rotation of one of cams 261. Additionally, it should be understood that other devices or methods may also be used to prevent inadvertent actuation of drive assembly 22 which may otherwise inadvertently cause electrical disengagement of test assembly 20 and/or insert assembly 22 from printed circuit assembly 40.

Above, the operation of assembly module 12 is generally described corresponding to actuation of drive assembly 22 in the direction indicated at 300 and 310 in respective FIGURES 8B and 8C and direction 350 in FIGURE 8E. However, it should be understood that reverse-actuation of drive assembly in a direction opposite of directions 300, 310 and 350 reverses the sequence, rate and movement direction of insert assembly 16, retention assembly 18 and test assembly 20. For example, in FIGURE 1, assembly module 12 is illustrated in a "closed" position, thereby resulting in engagement of insert assembly 16, test assembly 20 and retention assembly 18 with printed circuit assembly 40 with sockets 48 in a locked condition. Actuating drive assembly 22 in a direction opposite that indicated by 300 and 310 in respective FIGURES 8B and 8C and direction 350 in FIGURE 8E causes disengagement of test assembly 20 and insert assembly 16 from printed circuit assembly 40 while retention assembly 18 restrains movement of printed circuit assembly. Additionally, any compressive force applied to CPU 150 relative to printed circuit assembly 40 is released. Further, CPU 150 is unlocked from socket 48 via rotation of hex wrench support members 408. After disengagement of test assembly 20 and insert assembly 16, and correspondingly CPU 150 from socket 48, retention assembly 18 retracts from printed circuit assembly 40, thereby enabling a user to remove printed circuit assembly 40 from assembly module 12 by sliding support tray 24 outwardly from assembly module 12.

Thus, embodiments of the present invention enable an electronic component, such as a CPU, to be automatically installed or inserted into a socket of a printed circuit assembly and automatically locked in the socket. Embodiments of the present invention also enable testing of a printed circuit assembly with an installed electronic component, such as a CPU, in a socket by automatically engaging various components and/or areas of the printed circuit assembly. Further, embodiments of the present invention also enable automatic unlocking and removal of the electronic component from a printed circuit assembly.

## Claims

1. A printed circuit assembly (40) system (10), comprising:
an assembly module (12) adapted to automatically insert an electronic component (148) into a socket (48) of the printed circuit assembly (40) and automatically close the socket (48) to secure the electronic component (148) to the socket (48).

2. The system (10) of Claim 1, wherein the assembly module (12) is adapted to automatically open the socket (48) to facilitate removal of the electronic component (148) from the socket (48).

3. The system (10) of Claim 1, wherein the assembly module (12) is adapted to electrically engage another component of the printed circuit assembly (40) after securing the electronic component (148) to the socket (48).

4. The system (10) of Claim 1, wherein the assembly module (12) is adapted to automatically remove the electronic component (148) from the socket (48).

5. The system (10) of Claim 1, wherein the assembly module (12) is adapted to restrain the printed circuit assembly (40) during removal of the electronic component (148) from the socket (48).

6. The system (10) of Claim 1, wherein the assembly module (12) is adapted to prevent removal of the electronic component (148) from the socket (48) during testing of the printed circuit assembly (40).

7. The system (10) of Claim 1, wherein the assembly module (12) is adapted to enable translational movement of the electronic component (148) relative to the printed circuit assembly (40) to facilitate securing the electronic component (148) to the socket (48).

8. The system (10) of Claim 1, wherein the assembly module (12) is adapted to register a location of the socket (48) on the printed circuit assembly (40) to the electronic component (148).

9. The system (10) of Claim 1, wherein the assembly module (12) is adapted to enable electrical engagement to another component of the printed circuit assembly (40) to facilitate testing of the printed circuit assembly (40) with the electronic component (148).

10. The system (10) of Claim 1, wherein the assembly module (12) is adapted to visually indicate to a user a locked condition of the electronic component (148) with the socket (48).
